# EUROPEAN PATENT APPLICATION

(11) **EP 2 472 612 A1**
(43) Date of publication of application: **04.07.2012**
(21) Application number: 10197225.5
(22) Date of filing: 29.12.2010
(51) Int. Cl.: H01L 33/50, H01L 33/58, H01L 33/44

(54) **Improved angular color performance of white LED lighting systems**

(71) Applicant: Koninklijke Philips Electronics N.V., 5621 BA Eindhoven (NL)
(72) Inventor: Weijers, Aldegonda, L., 5600 AE Eindhoven (NL)
(74) Representative: Damen, Daniel Martijn

(57) **Abstract**

A white light-emitting diode, LED, with an improved angular performance is provided. The white LED (200) comprises a blue LED (202) which is arranged for emitting blue light and having a first angular emission profile, a phosphor-based conversion element (203) which is arranged for converting part of the blue light into yellow light and having a second angular emission profile which is different from the first angular emission profile, and a dichroic filter (204) which is arranged for converting the blue light and the yellow light into light (205) having a third angular emission profile with a natural color over angle variation. Such a natural color over angle variation of the emitted light may be achieved by correlating the color of light emitted into a certain angle with the intensity of that light.

## Description

### FIELD OF THE INVENTION

The invention relates in general to artificial lighting, and more specifically to white light-emitting diodes (LEDs).

### BACKGROUND OF THE INVENTION

White LEDs comprising blue LEDs and conversion elements based on yellow phosphor are well known in the art. Unfortunately, such white LEDs suffer from an angular color variation, i.e., a variation in color for light which is emitted into different angles, since the blue light and the yellow light are generated in different ways and at different locations within the white LED. This results in an unsatisfactory appearance of white LEDs when used as a light source and hampers the acceptance of white LEDs for high-quality lighting applications.

In known white LEDs, the color over angle is frequently improved by adding scattering centers. The scattering will render both the blue and the yellow emission more or less Lambertian, resulting in a reduced angular color variation and an improved mixing of the blue and the yellow light. However, the scattering contributes to losses which are typically estimated to be 5―20%.

### SUMMARY OF THE INVENTION

It is an object of the present invention to provide a more efficient alternative to the above techniques and prior art.

More specifically, it is an object of the present invention to provide white light-emitting diodes (LEDs) with an improved angular performance.

These and other objects of the present invention are achieved by means of a lighting device having the features defined in independent claim 1. Embodiments of the invention are characterized by the dependent claims.

According to an aspect of the invention, a lighting device is provided. The lighting device comprises a blue LED, i.e., a LED which is arranged for emitting blue light, and a phosphor-based conversion element. The blue LED has a first angular emission profile. The phosphor-based conversion element is arranged for converting part of the blue light into yellow light. The conversion element has a second angular emission profile. The second angular emission profile is different from the first angular emission profile. The lighting device further comprises a dichroic filter which is arranged for converting the blue light and the yellow light into light having a third angular emission profile. The third angular emission profile has a natural color over angle variation.

The present invention makes use of an understanding that the angular emission profile of white LEDs may be improved by converting the emitted blue light and yellow light into light having a natural color over angle variation, i.e., an angular emission spectrum which has a more natural appearance. A natural appearance of the emitted light may be achieved by correlating the color of light emitted into a certain angle with the intensity of that light. More specifically, a high light intensity is associated with a more bluish white color, i.e., a higher correlated color temperature (CCT), whereas a low light intensity is associated with a warmer color, i.e., a lower CCT. A white LED with such a natural angular emission profile is likely to gain acceptance since its appearance is much more similar to that of traditional lamps, such as incandescent or halogen lamps, to which customers are used to.

According to an embodiment of the invention, the third angular emission profile is characterized by a correlated color temperature of the converted light which increases with an increasing intensity of the converted light. The intensity is determined by an emission angle of the converted light.

According to an embodiment of the invention, the blue LED and the conversion element are comprised in a white LED. The dichroic filter is a coating which is applied to the conversion element.

According to an embodiment of the invention, the blue LED and the conversion element are comprised in a white LED. The white LED further comprises a package enclosing the blue LED and the conversion element. The dichroic filter is a coating which is applied to the package.

According to an embodiment of the invention, the blue LED and the conversion element are comprised in a lighting module. The lighting module further comprises a housing enclosing the blue LED and the conversion element. The lighting module further comprises an optical window which is arranged for emitting light from the lighting module. The dichroic filter is a coating which is applied to the optical window.

Further objectives of, features of, and advantages with, the present invention will become apparent when studying the following detailed disclosure, the drawings and the appended claims. Those skilled in the art realize that different features of the present invention can be combined to create embodiments other than those described in the following.

### BRIEF DESCRIPTION OF THE DRAWINGS

The above, as well as additional objects, features and advantages of the present invention, will be better understood through the following illustrative and nonlimiting detailed description of embodiments of the present invention, with reference to the appended drawings, in which:
Fig. 1 shows a known white LED.
Fig. 2 shows a LED according to an embodiment of the invention.
Fig. 3 illustrates a typical angular performance of a LED according to an embodiment of the invention.
Fig. 4 shows a LED according to another embodiment of the invention.
Fig. 5 shows a LED module according to an embodiment of the invention.

All the figures are schematic, not necessarily to scale, and generally only show parts which are necessary in order to elucidate the invention, wherein other parts may be omitted or merely suggested.

### DETAILED DESCRIPTION

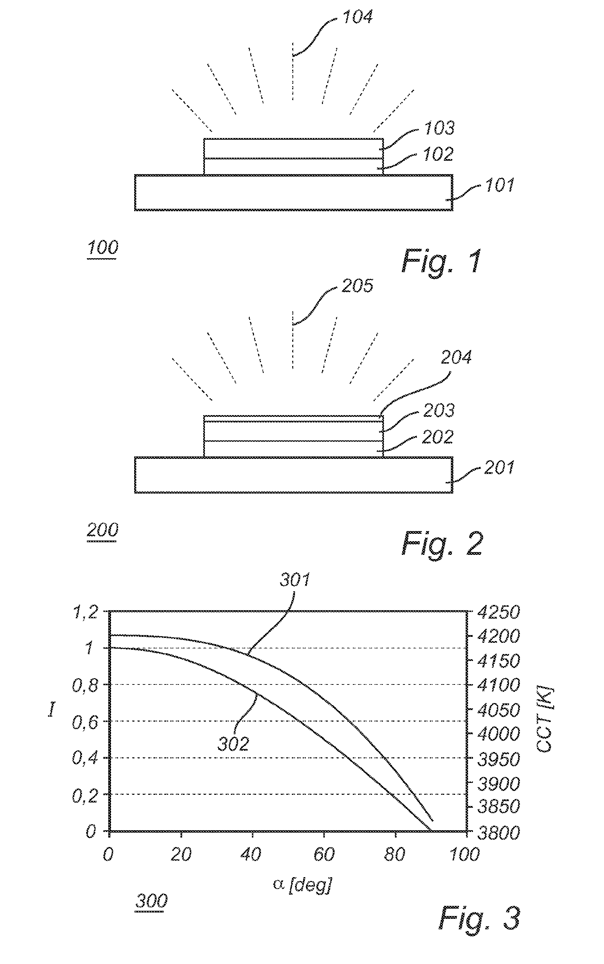

In Fig. 1, a white LED, i.e., a LED emitting white light, is illustrated. LED 100 comprises a LED 102 emitting blue light, which LED 102 is mounted on substrate 101, and a conversion layer 103 which is arranged for converting part of the blue light emitted by LED 102 into yellow light. Light 104 which is emitted from LED 100 is a mixture of blue and yellow light, emitted from LED 102 and conversion layer 103, respectively, and is perceived as white. Conversion layer 103 is typically based on yellow phosphor. White LEDs are also known as phosphor-converted LEDs (pc-LEDs).

The drawback of known white LEDs, such as described with reference to Fig. 1, is that they suffer from an angular color variation, i.e., the color of the emitted light varies with the angle of emission. Such an angular color variation is caused by the fact that the blue and the yellow light are generated in different ways and at different locations within LED 100, namely at LED 102 and conversion element 103, respectively. The angular variation hampers the acceptance of white LEDs for certain applications.

In many white LEDs the angular color variation, also referred to as color over angle, is reduced by scattering. This may, e.g., be achieved by adding scattering centers to a lens, or a housing, covering the white LED. The scattering results in a more or less Lambertian emission profile of both the blue and the yellow light, which improves the mixing and results in a lower angular color variation. However, the drawback of this solution is that the losses are increased due to the scattering by about 5―20%.

With reference to Fig. 2, a white LED according to an embodiment of the invention is described. LED 200 is similar to LED 100, described with reference to Fig. 1, in that it comprises a substrate 201, a blue LED 202, and a phosphor-based conversion element 203. LED 200 further comprises a dichroic filter 204 arranged on top of conversion element 303, such that the blue and the yellow light emitted from LED 202 and conversions element 203, respectively, passes filter 204. Upon passing filter 204, the color over angle of the blue light and the yellow light, respectively, are transformed into a color over angle which resembles that of a light source which is perceived as natural, such as an incandescent lamp. In other words, filter 204 is designed such that light 205 emitted by LED 200 has a color temperature which is dependent on the intensity of the light emitted with a certain angle. Exploiting this CCT renders the appearance of light 205 more natural.

In Fig. 3, a typical angular performance of a LED according to an embodiment of the invention is illustrated. Diagram 300 shows the CCT 301 and the intensity (I) 302 of the emitted light as a function of the emission angle α, which is defined relative to a surface normal of LED 200, described with reference to Fig. 2. By adjusting the color temperature in accordance with Fig. 3, the emitted light follows the so called black-body line. In other words, a high intensity is associated with a more bluish white color, i.e., a higher CCT, whereas a lower intensity is associated with a warmer color, i.e., a lower CCT. The resulting appearance of the emitted light is more natural to the viewer who is likely to be accustomed to incandescent and halogen lamps.

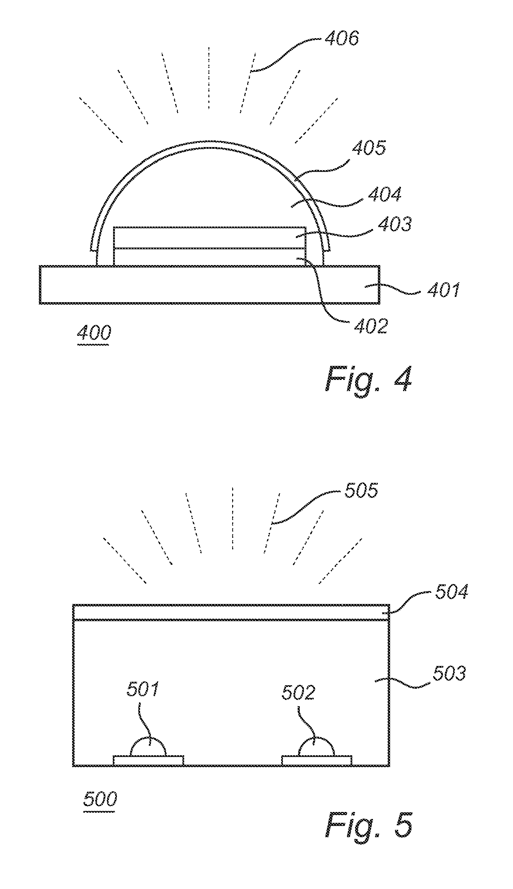

In Fig. 4, a LED according to another embodiment of the invention is illustrated. LED 400 is similar to LED 200, described with reference to Fig. 2, and comprises a substrate 401, a blue LED 402, and a conversion element 403, all of which are enclosed by a translucent or transparent housing 404. LED 400 differs from LED 200 in that a dichroic filter 405 is arranged on top of housing 404 such that blue and yellow light emitted by LED 402 and conversion element 403, respectively, pass through filter 405. The resulting light 406 which is emitted by LED 400 has a natural color over angle, as was described hereinabove with reference to Figs. 2 and 3.

With reference to Fig. 5, a LED module according to yet another embodiment of the invention is described. LED module 500 comprises two white LEDs 501 and 502, such as LED 100 described with reference to Fig. 1, which LEDs are enclosed by housing 503. Housing 503 is at least partially translucent or transparent such that light 505 may be emitted from module 500. Housing 503 is arranged with a dichroic filter 504 which is arranged such that blue and yellow light emitted from LEDs 501 and 502 passes filter 504. Light 505 which has passed filter 504 has a natural color over angle, as was described hereinabove with reference to Figs. 2 and 3. LED module 500 may comprise any number of LEDs suitable for the application at hand.

The person skilled in the art realizes that the present invention by no means is limited to the embodiments described above. On the contrary, many modifications and variations are possible within the scope of the appended claims. For example, the dichroic filter may be incorporated into a lens which a white LED is fitted with.

In conclusion, a white light-emitting diode with an improved angular performance is provided. The white LED comprises a blue LED which is arranged for emitting blue light and having a first angular emission profile, a phosphor-based conversion element which is arranged for converting part of the blue light into yellow light and having a second angular emission profile which is different from the first angular emission profile, and a dichroic filter which is arranged for converting the blue light and the yellow light into light having a third angular emission profile with a natural color over angle variation. Such a natural color over angle variation of the emitted light may be achieved by correlating the color of light emitted into a certain angle with the intensity of that light.

## Claims

1. A lighting device (200, 400, 500) comprising:
a light-emitting diode (202, 403, 501, 502), LED, being arranged for emitting blue light and having a first angular emission profile,
a phosphor-based conversion element (203, 403, 501, 502) being arranged for converting part of the blue light into yellow light and having a second angular emission profile which is different from the first angular emission profile, and
a dichroic filter (204, 405, 504) being arranged for converting the blue light and the yellow light into light (205, 406, 505) having a third angular emission profile with a natural color over angle variation.

2. The lighting device according to claim 1, wherein the third angular emission profile is **characterized by** a correlated color temperature (301) of the converted light (205, 406, 505) which increases with an increasing intensity (302) of the converted light, which intensity is determined by an emission angle (α) of the converted light.

3. The lighting device (200) according to claim 1, wherein the blue LED (202) and the conversion element (203) are comprised in a white LED (200), and wherein the dichroic filter is a coating (204) which is applied to the conversion element.

4. The lighting device (400) according to claim 1, wherein the blue LED (402) and the conversion element (403) are comprised in a white LED (400), the white LED further comprising a package (404) enclosing the blue LED and the conversion element, and wherein the dichroic filter is a coating (405) which is applied to the package.

5. The lighting device (500) according to claim 1, wherein the blue LED (501, 502) and the conversion element (501, 502) are comprised in a lighting module (500), which lighting module further comprises a housing (503) enclosing the blue LED and the conversion element and a window being arranged for emitting light from the lighting module, and wherein the dichroic filter is a coating (504) which is applied to the window.
